(19) Europäisches Patentamt / European Patent Office / Office européen des brevets

(11) **EP 1 881 358 A1**

(12) **EUROPEAN PATENT APPLICATION**

(43) Date of publication:
**23.01.2008 Bulletin 2008/04**

(51) Int Cl.:
*G02B 26/08* (2006.01)  *G02B 26/10* (2006.01)

(21) Application number: **06124134.5**

(22) Date of filing: **15.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **18.07.2006 KR 20060066702**

(71) Applicant: **Samsung Electronics Co., Ltd.**
**Suwon-si, Gyeonggi-Do (KR)**

(72) Inventors:
• **Cho, Jin Woo**
**449-712, Gyeonggi-do (KR)**

• **Jeong, Hee moon**
**449-712, Gyeonggi-do (KR)**
• **Ko, Young Chul**
**449-712, Gyeonggi-do (KR)**
• **Shin, Seong Ho**
**449-712, Gyeonggi-do (KR)**
• **Lee, Jin Ho**
**449-712, Gyeonggi-do (KR)**

(74) Representative: **Greene, Simon Kenneth**
**Elkington and Fife LLP**
**Prospect House**
**8 Pembroke Road**
**Sevenoaks,**
**Kent TN13 1XR (GB)**

(54) **Scanner**

(57)    A scanner for removing a high frequency component from an external input using a mechanical structure of the scanner is provided. The scanner includes a mirror; an internal gimbal which is provided around the mirror; an external gimbal which is provided around the internal gimbal, including a driving coil; a frame which is provided around the external gimbal; a first torsion axis which connects the mirror and the internal gimbal; a connection axis which connects the internal gimbal and the external gimbal, and is perpendicular to the first torsion axis; a second torsion axis which connects the external gimbal and the frame, and is parallel to the connection axis; and a magnet which forms a magnetic field having an angle with a direction of the second torsion axis, wherein a high frequency vibration is filtered through the connection axis and transferred to the mirror.

**FIG. 3**

**Description**

BACKGROUND OF THE INVENTION

Apparatuses consistent with the present invention relate to a scanner, and more particularly, to a scanner which can remove a particular high frequency component from an external input by providing a low pass filter with only a comparatively simple change of a mechanical design, and also can eliminate a tremor caused by a high frequency.

A scanner is usually used to change a path of a laser. Such a scanner may further be easily used for a laser printer, a bar code reader, and the like. In addition, the scanner may perform more complicated operations such as complex image processing, e.g., for a laser television or the like. In such an environment, a laser may be provided along a certain path as a light source, so that a desired image may be obtained by changing the path of the laser and scanning by using a scanner.

The scanner includes a mirror which is manufactured on a basis of Micro-Electro Mechanical System (MEMS) technology. In order to change the path of a laser, there is a method of two-dimensionally changing the path of a laser by moving one mirror with two axes.

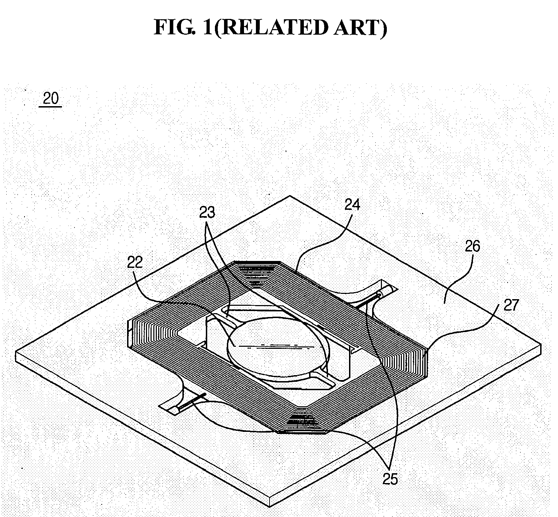

FIG. 1 is a perspective view illustrating a scanner according to a related art.

Referring to FIG. 1, a scanner 20 includes a mirror 22, a horizontal torsion axis 23, an internal frame 24, a vertical torsion axis 25 and an external frame 26. The mirror 22 is coated to be reflective at the center of the scanner 20. The horizontal torsion axis 23 is extended from the mirror 22 in opposite directions from each other. The internal frame 24 is physically connected to the horizontal torsion axis 23 and is provided around the mirror 22. The vertical torsion axis 25 is extended from the internal frame 24 and perpendicular to the horizontal torsion axis 23. The external frame 26 is physically connected to the vertical torsion axis 25.

Coils 27 are provided on the internal frame 24 which is in a gimbal structure. Accordingly, when a current is supplied to the coils 27, the internal frame 24 may react to an externally formed magnetic field and produce a moment capable of driving the scanner 20. When forming the magnetic field in a tilted direction towards the horizontal torsion axis 23 and the vertical torsion axis 25, and supplying a current to the coils 27, a torque occurs vertically with respect to the magnetic field and the current. As the generated torque is divided into two components of the horizontal torsion axis 23 and the vertical torsion axis 25, the mirror 22 may vibrate on the horizontal torsion axis 23. Also, the internal frame 24 and the mirror 22 may vibrate on the vertical torsion axis 25. As a result, with such dual axial vibrations with a single mirror, image signals may be two-dimensionally distributed.

Hereinafter, such a dual axial driving of a mirror will be further described in detail. To project an image on an externally located screen utilizing the scanner 20, scanning lines may be projected on the screen by vibrating the mirror 22 on the vertical torsion axis 25, e.g. vibrating the mirror 22 with a sawtooth waveform of about 60 Hz, and vibrating the mirror 22 on the horizontal torsion axis 23 with a sine wave of about 20 kHz which is a comparatively high frequency. Specifically, a high frequency vibration of the horizontal torsion axis 23 may horizontally scan a scanning line on the screen and a low frequency vibration of the vertical torsion axis 25 may vertically move the scanning line on the screen, thereby embodying a two-dimensional image on the screen.

Each moment for vertically and horizontally vibrating the mirror 22 may be provided to the mirror 22 as one synthesized moment. In this instance, such a synthesized moment has an approximate low frequency form in which a form of a high frequency signal is modulated in a low frequency signal as is.

It is assumed that a resonant frequency of a mass capable of vibrating on the vertical torsion axis 25 of the mirror 22 is designed to be about 1 kHz and a resonant frequency of a mass capable of vibrating on the horizontal torsion axis 23 of the mirror 22 is designed to be about 20 kHz. Under these conditions, when a current of a sawtooth wave of about 60 Hz and a current of a horizontal resonant frequency of about 20 kHz are modulated and supplied to the coils 27 of the internal frame 24, a moment is vertically generated with respect to an externally formed magnetic field. Such a moment is distributed to the horizontal torsion axis 23 and the vertical torsion axis 25, and used for actuating the mirror 22. In this instance, since the mirror 22 is oscillated at about 20 kHz on the horizontal torsion axis 23 by the synthesized moment, the mirror 22 does not react to a sawtooth wave component of about 60 Hz and is actuated in a sawtooth waveform of about 60 Hz on the vertical torsion axis 25.

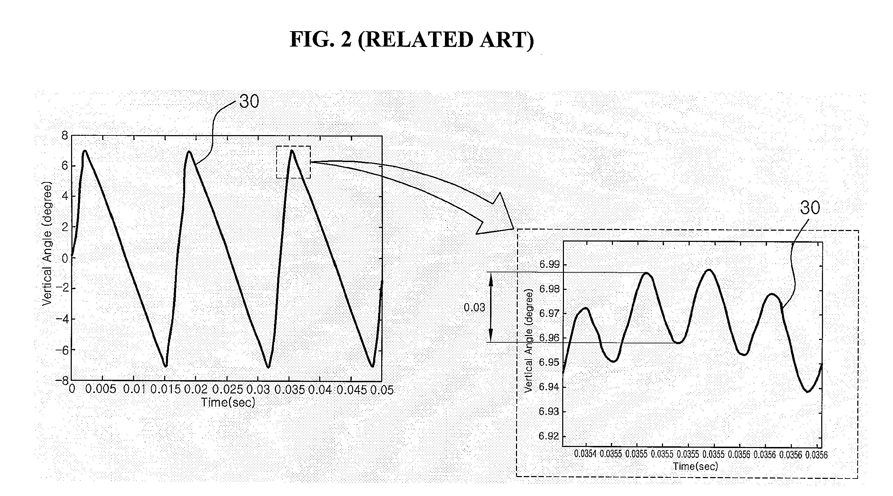

However, such a synthesized moment working on the vertical torsion axis 25 includes a sawtooth component of about 60 Hz and also includes a sine wave component of about 20 kHz. Accordingly, when vertically scanning, a minute tremor of about 20 kHz exists, as shown in FIG. 2. Specifically, while each of the vertical torsion axis 25 and the horizontal torsion axis 23 must be independently vibrated by a low frequency signal, e.g. 60 Hz, and a high frequency signal, e.g. 20 kHz, respectively, the high frequency signal affects the low frequency signal of the vertical torsion axis 25, which causes a minute tremor or noise. Referring to FIG. 2, it can be seen that a driving angle of the vertical torsion axis 25 according to time, i.e. a curve 30, may have a tremor of about 0.03 degrees due to a high frequency.

Such a tremor may prevent a scanning line from being scanned to a desired location and thus, deteriorate a resolution. Specifically, in the case of vertical scanning, horizontal scanning lines may be overlapped due to a tremor caused by a high frequency, and thus, may not embody a high resolution.

More specifically, when vertically scanning, such a tremor caused by a high frequency may prevent scanning lines from being scanned in an accurate location. Specifically, scanning lines may be overlapped with each other or excessively separated from each other. As described above, intervals between horizontal scanning lines may be irregular which may significantly deteriorate a resolution.

In order to overcome the disadvantages of such a tremor caused by a high frequency described above, a method of constructing a low pass filter as a circuit may be considered. However, since electric parts may be required, productivity may be deteriorated and a manufacturing cost may be increased.

In order to embody high definition (HD) image resolution, a size of a mirror and a driving angle should be increased. As an example, in order to embody HD image quality, a diameter of the mirror should be increased from about 1.0 mm in the related art to about 1.5 mm. Also, the driving angle should be increased from about 8 ° in the related art to about 15 °.

However, as the mirror moves at a higher speed and the diameter of the mirror becomes larger, a dynamic deformation becomes larger. A maximum dynamic deformation may be less than approximately one sixth of a laser wavelength or desirably one tenth of the laser wavelength so that an optical signal is emitted to a desired location. However, the related art mirror structure may not satisfy this requirement. When red, green, and blue (RGB) colors are used as a light source, a maximum dynamic deformation may be less than 45 nm which is about one tenth of 450 nm. In this instance, the 450 nm indicates a wavelength of the color green.

In order to reduce a dynamic deformation, a moment of inertia may be increased by increasing a thickness of the mirror. However, a high moment of inertia may cause an increase of rigidity of the mirror, and the driving angle of the mirror with respect to an identical torque becomes smaller. Accordingly, a high moment of inertia is not a suitable solution.

Specifically, a driving angle, a size of a mirror, and a dynamic deformation are relevant to each other and affect each other. Accordingly, development of an optimum mirror structure would be advantageous.

## SUMMARY OF THE INVENTION

According to an aspect of the present invention, there is provided a scanner. The scanner includes a mirror; an internal gimbal which is provided around the mirror; an external gimbal which is provided around the internal gimbal, including a driving coil; a frame which is provided around the external gimbal; a first torsion axis which connects the mirror and the internal gimbal; a connection axis which connects the internal gimbal and the external gimbal, and is perpendicular to the first torsion axis; a second torsion axis which connects the external gimbal and the frame, and is parallel to the connection axis; and a magnet which forms a magnetic field having an angle with a direction of the second torsion axis, wherein a high frequency vibration is filtered through the connection axis and transferred to the mirror.

The present invention aims to provide a scanner which can embody a high definition image quality by eliminating a tremor caused by a high frequency.

The present invention also aims to provide a scanner which does not need an electrical control and an additional part, and also is highly favorable to manufacturing and does not incur an additional cost by providing a low pass filter having a mechanical structure with only a comparatively simple change of a mechanical design.

The present invention also aims to provide a scanner which can precisely control a location by effectively eliminating an intervention of a high frequency, and when applied to a scanner, can also prevent a resolution from being deteriorated, which may be caused by overlapping scanning lines, by constantly maintaining a vertical isolation distance between scanning lines.

Embodiments of the present invention also provide a scanner which has a small dynamic deformation, while having a relatively large mirror and a relatively large driving angle, by providing a rib in a rear of a mirror, an external gimbal, an internal gimbal, and a torsion spring, and thereby may embody a high definition image quality.

## BRIEF DESCRIPTION OF THE DRAWINGS

The above and/or other aspects of the present invention will become apparent and more readily appreciated from the following detailed description, taken in conjunction with the accompanying drawings, in which:

FIG. 1 is a perspective view illustrating a scanner according to a related art;
FIG. 2 illustrates a movement of a vertical torsion axis with respect to time in a related art scanner;
FIG. 3 is a perspective view illustrating a scanner according to an exemplary embodiment of the present invention;
FIG. 4 is a configuration diagram modeling the present invention;
FIG. 5 is a graph illustrating a transmittance according to a frequency ratio;
FIG. 6 is a perspective view illustrating a synthesized driving power working on a scanner according to an exemplary embodiment of the present invention;

FIG. 7A is a graph illustrating a synthesized moment with respect to time,

FIG. 7B is a configuration diagram for simulating a scanner according to an exemplary embodiment of the present invention,

FIG. 7C illustrates a displacement of $x_2$ with respect to time;

FIG. 7D illustrates a displacement of $x_1$ with respect to time;

FIG. 8 is a perspective view illustrating a rear of a scanner, according to another exemplary embodiment of the present invention;

FIG. 9 is a perspective view illustrating a rear of a scanner, according to still another exemplary embodiment of the present invention; and

FIG. 10 is a perspective view illustrating a rear of a scanner, according to yet another exemplary embodiment of the present invention.

DETAILED DESCRIPTION OF

EXEMPLARY EMBODIMENTS OF THE INVENTION

Reference will now be made in detail to exemplary embodiments of the present invention, examples of which are illustrated in the accompanying drawings, wherein like reference numerals refer to the like elements throughout. The exemplary embodiments are described below in order to explain the present invention by referring to the figures.

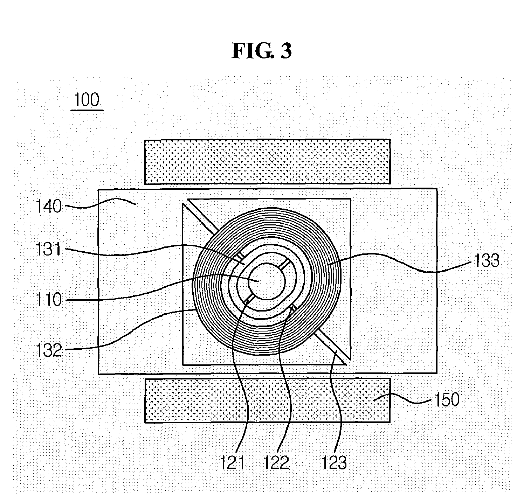

FIG. 3 is a perspective view illustrating a scanner according to an exemplary embodiment of the present invention.

As shown in FIG. 3, the scanner 100 according to an exemplary embodiment of the present invention includes a mirror 110. The mirror 110 reflecting a light source is provided on a center of the scanner, and an internal gimbal 131 is provided around the mirror 110. The internal gimbal 131 is approximately in a shape of an oval. However, other shapes are also contemplated. For example, the shape may be circular or polygonal. In the exemplary embodiment shown in Fig. 3, a shape of the oval is not a perfect circle, and similar to a ring. The mirror 110 and the internal gimbal 131 are connected by two first torsion axes 121, which form the first torsion axis, and are provided on sides of the internal gimbal 131 and the mirror 110. When the first torsion axes 121 are twisted, the mirror 110 and the internal gimbal 131 move relatively to each other.

An external gimbal 132 is provided around the internal gimbal 131. The external gimbal 132 is in an approximate shape of a disc, and a hole is formed in a center of the external gimbal 132 to accommodate the internal gimbal 131. The internal gimbal 131 and the external gimbal 132 are connected by two connection axes 122, which form a connection axis, and are provided on sides of the internal gimbal 131 and the external gimbal 132. When the connection axes 122 are twisted, the internal gimbal 131 and the external gimbal 132 move relative to each other.

A driving coil 133 is coiled on a front surface of the external gimbal 132 in a circular direction. The driving coil 133 and a magnetic field which is generated by a magnet 150 interact, and thereby enable the mirror 110 to vibrate. The magnet 150 may be a permanent magnet.

The first torsion axis is perpendicular to the connection axis. Specifically, the two first torsion axes 121 are formed on an identical axis. Also, the two connection axes 122 are formed on an identical axis.

A frame 140 is provided around the external gimbal 132. The frame 140 includes a space to include the external gimbal 132. The frame 140 and the external gimbal 132 are connected by two second torsion axes 123, which form a second torsion axis and are formed on an identical axis as the connection axis. The second torsion axis and the connection axis may be provided on an identical axis, or provided parallel to each other. The second torsion axis is perpendicular to the first torsion axis.

The magnet 150 is provided around the frame 140. The magnet 150 includes two magnets, and the two magnets 150 are arranged on opposite sides of the frame 140. Also, the magnet 150 generates a magnetic field. The magnetic field interacts with the driving coil 133, and thereby causes the mirror 110, the internal gimbal 131, and the external gimbal 132 to vibrate.

A direction of the magnetic field and an axis direction of the second torsion axis 123, have a certain angle. The certain angle may be predetermined. In this instance, the magnetic field is generated by the magnet 150 and the driving coil 133. The magnetic field is one synthesized moment to vibrate the mirror 100 vertically and horizontally, and may be provided to the mirror 100. In this instance, such a synthesized moment has an approximate low frequency form in which a form of a high frequency signal is modulated in a low frequency signal as is. A high frequency component of the synthesized moment is filtered and eliminated via the connection axis 122, and transferred to the mirror 110. Accordingly, a tremor due to a high frequency with respect to the second torsion axis 123 may be eliminated.

A rotational motion of the mirror with respect to the first torsion axis is a resonant motion, and used in a horizontal scanning. The rotational motion of the mirror with respect to the first torsion axis may be a high frequency which is approximately greater than 15 kHz, although the frequency will depend on a resolution. A rotational motion of the mirror with respect to the second torsion axis is a non-resonant motion in a sawtooth waveform of about 60 Hz. To actuate the mirror by the first torsion axis and the second torsion axis, a driving coil is provided around the external gimbal. A current of a high frequency and a current of a low frequency of the sawtooth waveform are modulated and supplied to the driving coil. A moment is generated in the external gimbal by a magnetic field caused by the magnet. The moment is distributed to the first torsion axis and the second torsion axis, and oscillates the external gimbal.

In this instance, the moment includes a high frequency component and a low frequency component. The high frequency component of a vibration component towards the first torsion axis is identical to a natural frequency of rotation of the mirror. Accordingly, the mirror is resonated on the first torsion axis. Also, the external gimbal rotates in a direction of the second torsion axis. In this instance, a rotational frequency mainly includes the low frequency component of the sawtooth waveform. However, the rotational frequency also includes the high frequency component of the rotational component. Such a low frequency rotational motion of the external gimbal on the second torsion axis travels through the connection axis to the mirror.

Accordingly, the mirror rotates in a low frequency on the second torsion axis. Also, a high frequency rotational motion of the external gimbal on the second torsion axis is not required to be transferred to the mirror through the connection axis. Accordingly, a natural frequency of the internal gimbal is advantageously below $1/\sqrt{2}$ of a frequency to be filtered from a frequency of the external input vibrating the external gimbal on the second torsion axis.

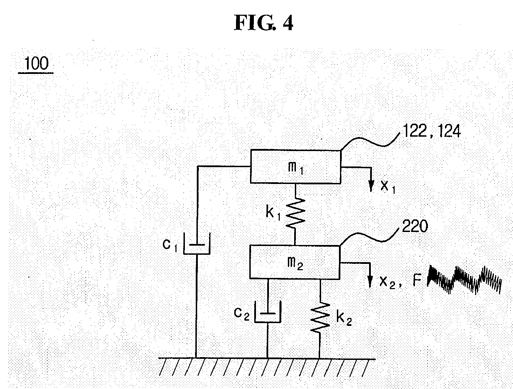

FIG. 4 is a configuration diagram modeling a vertical axial behavior according to an exemplary embodiment of the present invention.

As shown in FIG. 4, the scanner 100 of an exemplary embodiment of the present invention may be modeled with a second system. In this instance, m1 denotes a moment of inertia of the internal gimbal 131 and the mirror 110, k1 denotes a rigidity coefficient of the connection axis 122, c1 denotes a damping coefficient, m2 denotes a moment of inertia of the external gimbal 132, k2 denotes a rigidity coefficient of the first torsion axis 121, and c2 denotes a damping coefficient. In this case, the scanner 100 may be modeled by,

[Equation 1]

$$m_1 \cdot d^2 x_1 / dt^2 + c_1 \cdot dx_1 / dt + (x_1 - x_2)\, k_1 = 0$$
$$m_2 \cdot d^2 x_2 / dt^2 + c_2 \cdot dx_2 / dt + (k_1 + k_2)\, x_2 - k_1\, x_1 = F$$

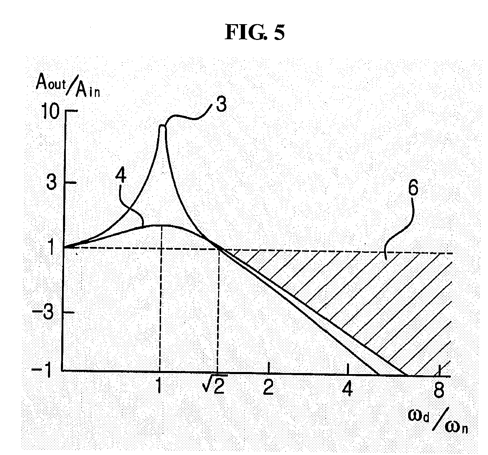

To observe the movement of the mirror 110 and the internal gimbal 131, a natural frequency of the mirror 110 and the internal gimbal 131 is wn. In this instance, $w_n$ is a natural frequency when the mirror 110 and the internal gimbal 131 vibrate on the connection axis. In the second system of the scanner 100, a vibration of m2 by the external input F generates a low frequency component in the form of a sawtooth wave and a high frequency component in the form of a sine wave. In this instance, a vibration x1 of m1 is determined by a vibration and a vibration of m2. Generally, when a vibration having a size $A_{in}$ and a frequency $W_d$ is supplied to a base, response properties of a spring-mass-damper system connected to the base is known, as in FIG. 5. In this instance, a frequency ratio and a transmittance are defined by Equation 2 and 3, respectively, below.

[Equation 2]

$$\text{Frequency ratio} = w_d \,/\, w_n$$

[Equation 3]

$$\text{Transmittance} = A_{out}/A_{in}$$

In this instance, $A_{out}$ indicates an amplitude with respect to a vibration of a mass by a vibration of the base. The relation between the frequency ratio and the transmittance is shown in FIG. 5. In FIG. 5, the x axis indicates the frequency ratio and the y axis indicates the transmittance in a log scale.

As shown in FIG. 5, the transmittance shows the largest amplitude when an external input that is identical to a natural frequency is input, i.e. where the x value is 1. Also, when a vibration having a significantly lower frequency than a natural frequency is input, the transmittance is nearer to 1. Also, the transmittance enters a buffer zone 6 where the frequency ratio is above $\sqrt{2}$. In this instance, the buffer zone 6 indicates an area where the transmittance is below

1, in which $A_{out}$ becomes less than $A_{in}$. A curve 3 indicates a property curve with a low damping coefficient, such as a rubber and silicon. A curve 4 indicates a property curve with high damping coefficient. Specifically, when the frequency ratio is more than $\sqrt{2}$ regardless of the damping coefficient value, the transmittance enters the buffer zone 6 where a high frequency component may be filtered. In other words, to make a system less affected by a high frequency vibration which is transmitted from an outside, a natural frequency of the system may be designed to be below $1/\sqrt{2}$ with respect to the high frequency that is transmitted from the outside.

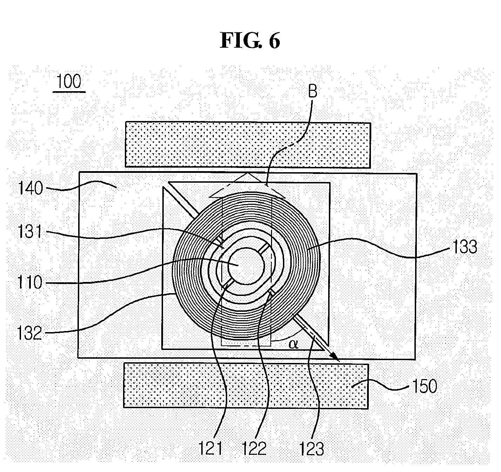

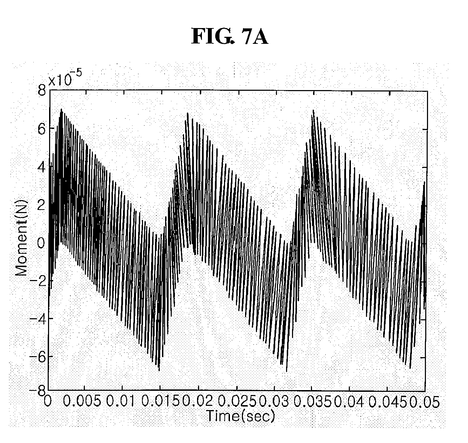

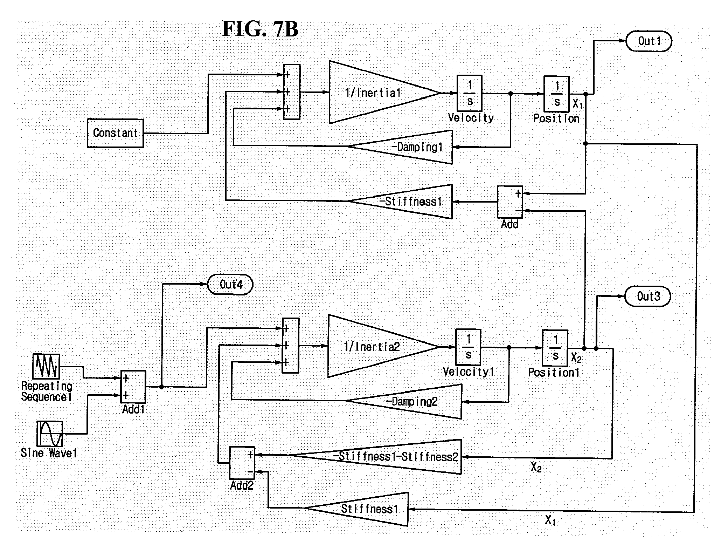

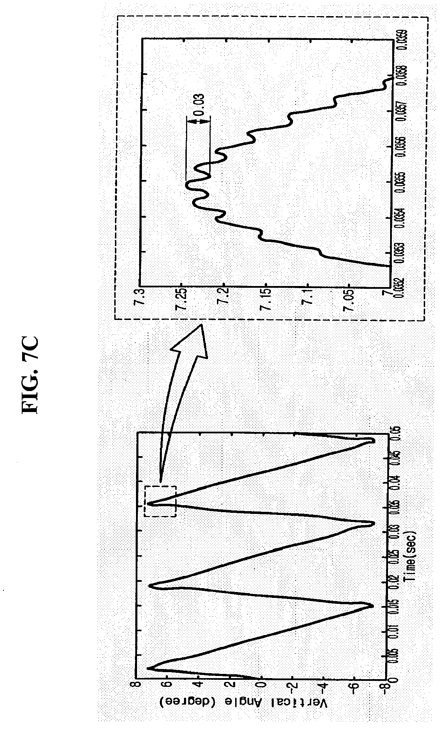

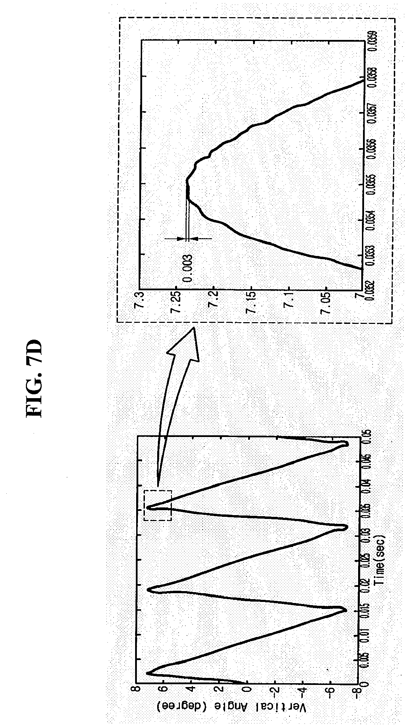

Hereinafter, an operation and effect of an exemplary embodiment of the present invention will be described. FIG. 6 is a perspective view illustrating a synthesized moment B working on a scanner 100 according to an exemplary embodiment of the present invention, FIG. 7A is a graph illustrating a synthesized moment B with respect to a time, FIG. 7B is a configuration diagram for simulating a scanner 100 according to an exemplary embodiment of the present invention, FIG. 7C illustrates a displacement of $x_2$ with respect to time, and FIG. 7D illustrates a displacement of $x_1$ with respect to a time.

As shown in FIGS. 6 and 7A through 7D, a synthesized moment B is applied to an external gimbal 132. As described above, the synthesized moment B is generated by synthesizing and modulating a vertical drive signal and a horizontal drive signal which are a comparatively low frequency. The synthesized moment B is applied at a certain angle between the first torsion axis and the second torsion axis. With assumptions that a vertical drive signal is approximately 60 Hz and a high frequency signal is approximately 20 kHz, the synthesized moment B thereof is shown in FIG. 7A. Also, a MATLAB Simulink model for a simulation of the present system which is modeled as Equation 1 is shown in FIG. 7B.

In this instance, it is assumed that the external gimbal 132 is designed to vibrate on the second torsion axis when a resonant frequency is about 1 kHz and the mirror 110 is designed to vibrate on the first torsion axis when a resonant frequency is about 20 kHz. Under these conditions, when the synthesized moment B is applied to the external gimbal 132, the synthesized moment B may be divided into two components to vertically and horizontally vibrate the external gimbal 132. Specifically, since a vibration of the external gimbal 132 on the first torsion axis includes both components, i.e. 60 Hz and 20 kHz, and is also identical to a resonant frequency of about 20 kHz, of the mirror 110, a transmittance may be significantly increased. Also, the mirror 100 is oscillated, shows a very huge displacement on the first torsion axis 121, and is vibrated in a sine waveform.

Also, a synthesized moment vibrates the external gimbal 132 on the second torsion axis. In this instance, the synthesized moment B also includes both components, i.e. 60 Hz and 20 kHz. Accordingly, since the external gimbal 132 is designed to have a resonant frequency of about 1 kHz, a vibration component of about 20 kHz weakly exists and a component of about 60 Hz is mainly vibrated in a sawtooth waveform.

In this instance, as shown in FIG. 7C, a displacement $x_2$ of the external gimbal 132 is shown in a sawtooth waveform, but a high frequency vibration is also minutely generated by a high frequency moment. However, when a resonant frequency of the internal gimbal 131 and the mirror 110 vibrating on the connection axis is designed to be about 8 kHz below about 20 kHz, it can be seen in the simulation shown in FIG. 7D that a high frequency component is almost completely filtered in the movement of the internal gimbal 131 and the mirror 110, and a tremor of the internal gimbal 131 and the mirror 110 is significantly reduced by about 1/10. This is because a vibration component, at about 20 kHz, of the external gimbal 132 is barely transmitted to the internal gimbal 131 and the mirror 110 having a resonant frequency of about 8 kHz. Specifically, since a mechanical structure between the internal gimbal 131 and the connection axis functions as a low pass filter, the mirror 110 may be prevented from vibrating at a high frequency on the second torsion axis . Accordingly, a vertical isolation distance between horizontal scanning lines may be constant and not overlap the scanning lines, and a resolution may be improved.

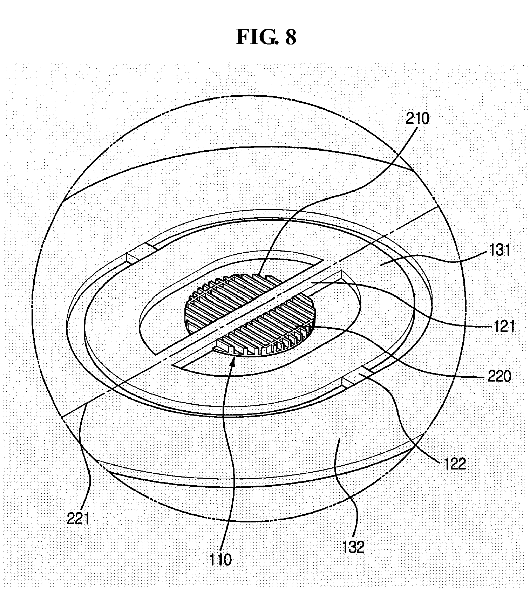

FIG. 8 is a perspective view illustrating a rear of a scanner, according to another exemplary embodiment of the present invention. As shown in FIG. 8, a plurality of vertical ribs 210 and at least one horizontal rib 220 are formed in a rear of a mirror 110.

A plurality of vertical ribs 210 are spaced apart from each other by a certain distance. The certain distance may be predetermined. The horizontal rib 220 is spaced apart from a center of a central axis by a certain distance, which may be predetermined, and perpendicular to the vertical ribs 210. The central axis 221 refers to a virtual axis which passes a center of the mirror 110 and passes through a center of the first torsion axes 121.

The vertical ribs 210 and the horizontal rib 220 may be formed by etching a rear of a silicon. Also, the vertical ribs 210 and the horizontal rib 220 may be formed by stacking a plurality of substrates and etching a bottom substrate of each of the plurality of substrates. The vertical ribs 210 and the horizontal rib 220 may reduce a moment of inertia of the mirror 110.

However, only the vertical ribs 210 may not be satisfied with a dynamic deformation, since a rigidity of the vertical ribs 210 is low. This is because a top surface of each of the vertical ribs 210 is connected to the mirror 110, and a thickness of the mirror 110 is reduced to between about 20 $\mu$m and about 40 $\mu$m by etching. Accordingly, it is advantageous to have the horizontal rib 220 which is perpendicular to the vertical ribs 210. However, when connecting a plurality of horizontal ribs 220, the moment of inertia of the mirror 110 may be increased. Accordingly, a desirable driving angle may not be obtained. Thus, it is advantageous that a horizontal rib is provided and a position of the horizontal rib is optimized, and thus, the dynamic deformation may be reduced. A location of the horizontal rib depends on a size of the mirror. The horizontal rib may be spaced apart from the central axis 221 by a distance between about 70% and about 90% of a radius of the mirror 110. In the exemplary embodiment shown in FIG. 8, a horizontal rib 220 is formed on either side of the central axis 221.

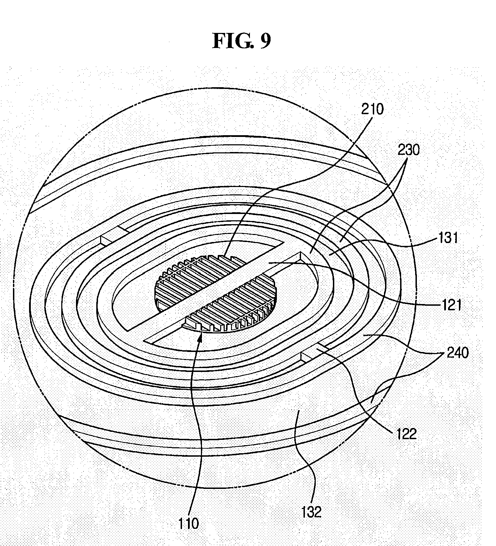

FIG. 9 is a perspective view illustrating a rear of a scanner, according to still another exemplary embodiment of the present invention.

As shown in FIG. 9, a first circular rib 230 may be formed by etching a portion of a rear of an internal gimbal 131. The first circular rib 230 is provided in a circular shape on the internal gimbal 131. In this instance, a single first circular rib 230 may be protruded from an inner side or an outer side of the rear of the internal gimbal 131. Alternatively, the first circular rib 230 may be protruded from the inner side and the outer side of the rear of the internal gimbal 131, respectively. A location or a number of the first circular rib 230 may be varied by altering a scanner according to an exemplary embodiment of the present invention.

A second circular rib 240 is formed by etching a portion of a rear of an external gimbal 132. The second circular rib 240 is provided in a circular shape on the external gimbal 132. A location or a number of the second circular rib 240 may be varied as is the case with the first circular rib 230.

The first circular rib 230 and the second circular rib 240 may be formed by stacking a plurality of substrates and etching a bottom substrate of each of the plurality of substrates. The first circular rib 230 and the second circular rib 240 may reduce a moment of inertia of the internal gimbal 131 and the external gimbal 132. Accordingly, flexibility in design may be improved.

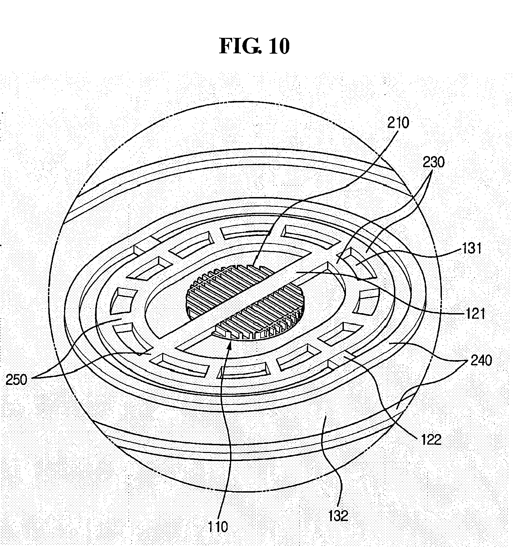

FIG. 10 is a perspective view illustrating a rear of a scanner, according to yet another exemplary embodiment of the present invention.

As shown in FIG. 10, a radial rib 250 may be protruded from a rear of an external gimbal 131. In this instance, a first circular rib 230 illustrated in FIG. 9 may also be provided. A plurality of radial ribs 250 may be provided to connect a plurality of first circular ribs 230. Also, a single first circular rib 230 may be formed, and the plurality of radial ribs 250 may be provided to pass through the single first circular rib 230.

The radial rib 250 may be protruded from a rear of an external gimbal 132. The radial rib 250 may be provided by stacking a plurality of substrates and etching a bottom substrate of each of the plurality of substrates. The radial rib 250 may reduce a moment of inertia of an internal gimbal 131 and the external gimbal 132. Accordingly, a flexibility of a design may be improved.

According to a further embodiment of the present invention, a rib may be protruded from a rear of the first torsion axes 121, the second torsion axes 123, or the connection axes 122, separately or respectively.

The rib may improve a kinetic nature of the scanner. Specifically, a rigidity of an axis may be controlled by suitably etching the rear of the first torsion axis, the second torsion axis, or the connection axis, excluding a space used for the rib. Thus, a convenience of designing the scanner may be provided.

Thus, according to an exemplary embodiment of the present invention, a scanner has a property of a low pass filter for removing a particular high frequency component due to its mechanical structure.

According to an exemplary embodiment of the present invention, a scanner does not need an electrical control and an additional part, and also is highly favorable to manufacturing and does not incur an additional cost by providing a low pass filter due to its mechanical structure with only a comparatively simple change of a mechanical design.

According to an exemplary embodiment of the present invention, a scanner can precisely control a location by effectively eliminating an intervention of a high frequency, and when applied to a scanner, can also prevent a resolution from being deteriorated, which may be caused by overlapping scanning lines, by constantly maintaining a vertical isolation distance between scanning lines.

According to an exemplary embodiment of the present invention, a scanner has a structure where a small dynamic deformation, while having a large mirror and a large driving angle, by providing a rib in a rear of a mirror, an external gimbal, an internal gimbal, and torsion spring, and thereby may embody a high definition image quality.

According to an exemplary embodiment of the present invention, a scanner separately or respectively provides a rib in a rear of a first torsion axis, a second torsion axis, or a connection axis, and thereby may improve a kinetic nature of the scanner, and provide a convenience of designing the scanner.

Although a few exemplary embodiments of the present invention have been shown and described, the present invention is not limited to the described exemplary embodiments. Instead, it would be appreciated by those skilled in the art that changes may be made to these exemplary embodiments without departing from the principles of the invention, the scope of which is defined by the claims and their equivalents.

**Claims**

1.  A scanner comprising:

a mirror;

an internal gimbal which is provided around the mirror;

an external gimbal which is provided around the internal gimbal, including a driving coil;

a frame which is provided around the external gimbal;

a first torsion axis which connects the mirror and the internal gimbal;

a connection axis which connects the internal gimbal and the external gimbal, and is perpendicular to the first torsion axis;

a second torsion axis which connects the external gimbal and the frame, and is parallel to the connection axis; and

a magnet which forms a magnetic field having an angle with a direction of the second torsion axis,

wherein a high frequency vibration is filtered through the connection axis and transferred to the mirror.

2. The scanner of claim 1, wherein the mirror externally scans a light source by reflecting the light source.

3. The scanner of claim 1 or 2, wherein the mirror is vibrated on the first torsion axis and the second torsion axis by a driving power which is generated by the magnetic field and the driving coil.

4. The scanner of any preceding claim, wherein the high frequency vibration is a vibration of vibration components vibrating on the second torsion axis.

5. The scanner of any preceding claim, wherein a natural frequency of the mirror which vibrates on the first torsion axis is larger than a natural frequency of the external gimbal which vibrates on the second torsion axis.

6. The scanner of claim 5, wherein a natural frequency of the internal gimbal is below about $1/\sqrt{2}$ of a frequency to be filtered from a frequency of an external input which vibrates the external gimbal on the second torsion axis.

7. The scanner of any preceding claim, wherein a rib is protruded from a rear of the mirror.

8. The scanner of claim 7, wherein the rib comprises:

a plurality of vertical ribs which are perpendicular to the first torsion axis; and

at least one horizontal rib which is spaced apart from the first torsion axis by a certain distance, and is perpendicular to the plurality of vertical ribs.

9. The scanner of claim 8, wherein the at least one horizontal rib is spaced apart from a central axis by a distance which is between about 70% and about 90% of a radius of the mirror.

10. The scanner of claim 7, 8 or 9, wherein the rib is formed by stacking a plurality of substrates and etching a bottom substrate of each of the plurality of substrates.

11. The scanner of any preceding claim, wherein a circular rib is protruded from a rear of the internal gimbal or the external gimbal in a circular shape.

12. The scanner of claim 11, wherein the circular rib is formed by stacking a plurality of substrates and etching a bottom substrate of each of the plurality of substrates.

13. The scanner of any preceding claim, wherein a plurality of radial ribs are protruded from a rear of the internal gimbal or the external gimbal in a radial shape.

14. The scanner of claim 13, wherein the radial ribs are formed by stacking a plurality of substrates and etching a bottom substrate of each of the plurality of substrates.

15. The scanner of any preceding claim, wherein a rib is protruded from a rear of at least one of the first torsion axis, the second torsion axis, and the connection axis.

16. The scanner of any preceding claim, wherein a rib is protruded from a rear of at least two of the first torsion axis, the second torsion axis, and the connection axis.

## FIG. 1(RELATED ART)

FIG. 2 (RELATED ART)

**FIG. 3**

# FIG. 4

# FIG. 5

## FIG. 6

## FIG. 7A

# FIG. 7B

**FIG. 7C**

EP 1 881 358 A1

## FIG. 7D

FIG. 8

## FIG. 9

**FIG. 10**

**European Patent Office**

## EUROPEAN SEARCH REPORT

Application Number

EP 06 12 4134

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2005 250078 A (CANON KK) 15 September 2005 (2005-09-15) * abstract; figure 1 * ----- | 1-16 | INV. G02B26/08 G02B26/10 |
| X | US 2005/253055 A1 (SPRAGUE RANDALL B [US] ET AL) 17 November 2005 (2005-11-17) * paragraph [0095]; figure 5 * ----- | 1-16 | |
| X | JP 07 027989 A (FUJI ELECTRIC CO LTD) 31 January 1995 (1995-01-31) * abstract; figure 1 * ----- | 1-16 | |
| A | US 5 969 465 A (NEUKERMANS ARMAND P [US] ET AL) 19 October 1999 (1999-10-19) * abstract; figures 12,13 * ----- | 1 | |
| A | US 5 488 863 A (MOCHIDA YOICHI [JP] ET AL) 6 February 1996 (1996-02-06) * abstract; figure 3A * ----- | 1 | |
| | | | TECHNICAL FIELDS SEARCHED (IPC) G02B |

The present search report has been drawn up for all claims

| Place of search | Date of completion of the search | Examiner |
|---|---|---|
| The Hague | 16 July 2007 | Lehtiniemi, Henry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 12 4134

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2007

| Patent document cited in search report | | Publication date | Patent family member(s) | | Publication date |
|---|---|---|---|---|---|
| JP 2005250078 | A | 15-09-2005 | NONE | | |
| US 2005253055 | A1 | 17-11-2005 | NONE | | |
| JP 7027989 | A | 31-01-1995 | JP | 3214583 B2 | 02-10-2001 |
| US 5969465 | A | 19-10-1999 | NONE | | |
| US 5488863 | A | 06-02-1996 | DE | 69401607 D1 | 13-03-1997 |
| | | | DE | 69401607 T2 | 04-09-1997 |
| | | | EP | 0620415 A1 | 19-10-1994 |
| | | | JP | 3123301 B2 | 09-01-2001 |
| | | | JP | 6300570 A | 28-10-1994 |

EPO FORM P0459

For more details about this annex : see Official Journal of the European Patent Office, No. 12/82